(19) Europäisches Patentamt / European Patent Office / Office européen des brevets

(11) **EP 3 199 965 B1**

(12) **EUROPEAN PATENT SPECIFICATION**

(45) Date of publication and mention
of the grant of the patent:
**14.11.2018 Bulletin 2018/46**

(21) Application number: **15843848.1**

(22) Date of filing: **25.09.2015**

(51) Int Cl.:
*G01R 33/09* *(2006.01)*      *G01R 33/02* *(2006.01)*
*H01L 43/08* *(2006.01)*

(86) International application number:
**PCT/JP2015/077192**

(87) International publication number:
**WO 2016/047782 (31.03.2016 Gazette 2016/13)**

(54) **MAGNETIC SENSOR**

MAGNETISCHER SENSOR

CAPTEUR MAGNÉTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.09.2014   JP 2014196987**

(43) Date of publication of application:
**02.08.2017   Bulletin 2017/31**

(73) Proprietor: **Asahi Kasei Microdevices Corporation
Tokyo 101-8101 (JP)**

(72) Inventors:
• **SHIKAMA Takahisa
Tokyo 101-8101 (JP)**

• **FUJIMOTO Yoshinobu
Tokyo 101-8101 (JP)**

(74) Representative: **Hoffmann Eitle
Patent- und Rechtsanwälte PartmbB
Arabellastraße 30
81925 München (DE)**

(56) References cited:
| | |
|---|---|
| WO-A1-2008/146809 | WO-A1-2013/118498 |
| WO-A1-2014/101622 | JP-A- 2008 516 225 |
| JP-A- 2014 153 054 | JP-A- 2014 153 054 |
| US-A1- 2013 221 949 | US-A1- 2013 299 930 |
| US-A1- 2014 159 717 | |

EP 3 199 965 B1

**Description**

BACKGROUND

1. TECHNICAL FIELD

The present invention relates to a magnetic sensor.

2. RELATED ART

Conventionally, a tunnel magneto-resistance (TMR) element that detects presence or absence of magnetism in one predetermined direction has been known. Also, a magnetic sensor formed by combining a magneto-resistance element and a magnetic converging part has been known (please see Patent Documents 1 to 7, for example).

Patent Document 1: Japanese Patent Application Publication No. 2006-3116
Patent Document 2: Japanese Patent Application Publication No. 2006-10461
Patent Document 3: Japanese Patent Application Publication No. H7-169026
Patent Document 4: Japanese Patent Application Publication No. 2002-71381
Patent Document 5: Japanese Patent Application Publication No. 2004-6752
Patent Document 6: Japanese Patent Application Publication No. 2003-282996
Patent Document 7: WO2011/068146

Other examples can be seen in documents US 2013/299930 A1, US 2014/159717 A1, JP 2014 153054, WO 2014/101622 A1 and US 2013/221949A1.

A TMR element has: a linear region where a resistance value is approximately proportional to an external magnetic field; and a saturation region where a resistance value is predetermined regardless of an external magnetic field. Outside its linear region, a magnetic sensor using a TMR element cannot detect an external magnetic field accurately. For this reason, the external magnetic field detection range of a TMR element is restricted by the magnitude of its saturation magnetic field. In the case of a magnetic sensor that gathers, by a magnetic converging part and toward the magnetically sensitive-axis direction of a TMR element, magnetic fields oriented in directions different from the magnetically sensitive-axis direction, the single TMR element detects both a magnetic field oriented in the magnetically sensitive-axis direction and the magnetic fields oriented in the directions different from the magnetically sensitive-axis direction, posing an issue that saturation of magnetic fields easily occurs.
The invention aims to provide a magnetic sensor in which each magnetic detecting part can accurately detect a component of a magnetic field oriented in the same direction as the magnetically sensitive axis. The invention is defined by claim 1.

SUMMARY

A first aspect of the present invention provides a magnetic sensor including: a substrate; a magnetic converging part that is arranged on the substrate or in the substrate and has one or more magnetic converging members; a plurality of magnetic detecting parts that are arranged in proximity of the magnetic converging members and have magnetically sensitive axes oriented parallel with a plane of the substrate; and a calculating part that calculates, from an output of the plurality of magnetic detecting parts, external magnetic fields oriented in at least two directions among: an external magnetic field oriented in a first-axis direction parallel with the plane of the substrate; an external magnetic field oriented in a second-axis direction parallel with the plane of the substrate and vertical to the first-axis direction; and an external magnetic field oriented in a third-axis direction vertical to the plane of the substrate, wherein the magnetic converging part converts, at each magnetic detecting part among the plurality of magnetic detecting parts, an external magnetic field oriented in a direction different from the magnetically sensitive-axis direction to a magnetic field oriented in the magnetically sensitive-axis direction, the each magnetic detecting part includes a plurality of magneto-resistance elements arrayed parallel with the plane of the substrate, each magneto-resistance element among the plurality of magneto-resistance elements includes a laminated-layer structure formed of: a free layer in which a magnetization direction is changed by the external magnetic field; a pinned layer with fixed magnetization; and a spacer layer provided between the free layer and the pinned layer, a longitudinal direction of the free layer of one magneto-resistance element included in the plurality of magneto-resistance elements coincides with a longitudinal direction of the free layer of at least one magneto-resistance element adjacent to the one magneto-resistance element, and the at least one magneto-resistance element adjacent to the one magneto-resistance element is arrayed in the longitudinal direction of the free layer of the one magneto-resistance element. The magnetically sensitive-axis direction coincides with a magnetization direction of the pinned layer. The free layer of the one magneto-resistance element and the free layer of the at least one magneto-resistance element are arrayed in a direction orthogonal to the magnetically sensitive axis, and have longitudinal directions in a direction orthogonal to the magnetically sensitive axis.

The summary clause does not necessarily describe all necessary features of the embodiments of the present invention. The present invention may also be a sub-combination of the features described above.

BRIEF DESCRIPTION OF THE DRAWINGS

Fig. 1 shows an exemplary plan view of a magnetic detecting part 110.
Fig. 2 shows an exemplary cross-sectional view of the magnetic detecting part 110.
Fig. 3 shows an exemplary cross-sectional view of the magnetic detecting part 110.
Fig. 4 shows an exemplary cross-sectional view of the magnetic detecting part 110.
Fig. 5 shows an exemplary configuration of the magnetic detecting part 110.
Fig. 6 shows an exemplary magnetic detecting part 115.
Fig. 7 shows a resistance change rate observed when an external magnetic field is applied to a magnetic detecting part.
Fig. 8 is a figure for explaining a reason why the detectable magnetic field range becomes wide in the case of vertically-serial arraying.
Fig. 9 is a figure for explaining a bias magnetic field applied to a free layer 23.
Fig. 10 shows one example of a magnetic sensor 100.
Fig. 11 shows an exemplary configuration of the magnetic sensor 100.
Fig. 12 is a figure for explaining operation of the magnetic sensor 100.
Fig. 13 shows an exemplary configuration of the magnetic sensor 100.

DESCRIPTION OF EXEMPLARY EMBODIMENTS

Hereinafter, (some) embodiment(s) of the present invention will be described. The embodiment(s) do(es) not limit the invention according to the claims, and all the combinations of the features described in the embodiment(s) are not necessarily essential to means provided by aspects of the invention.

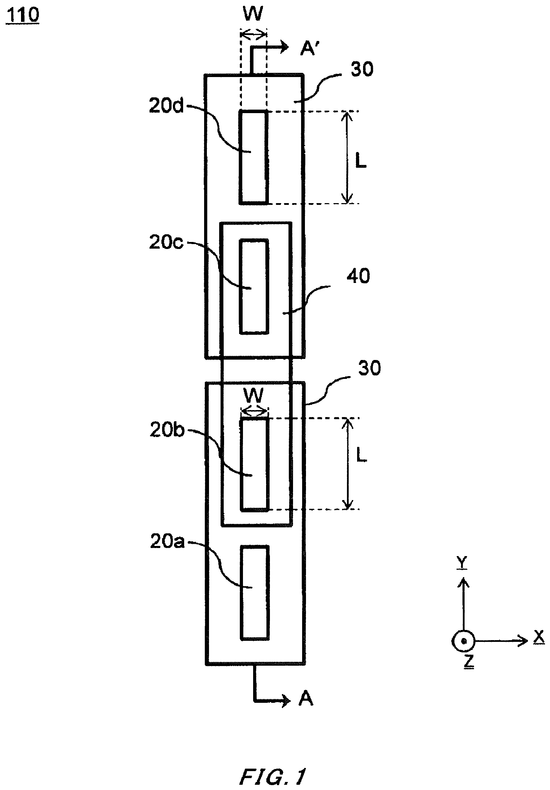

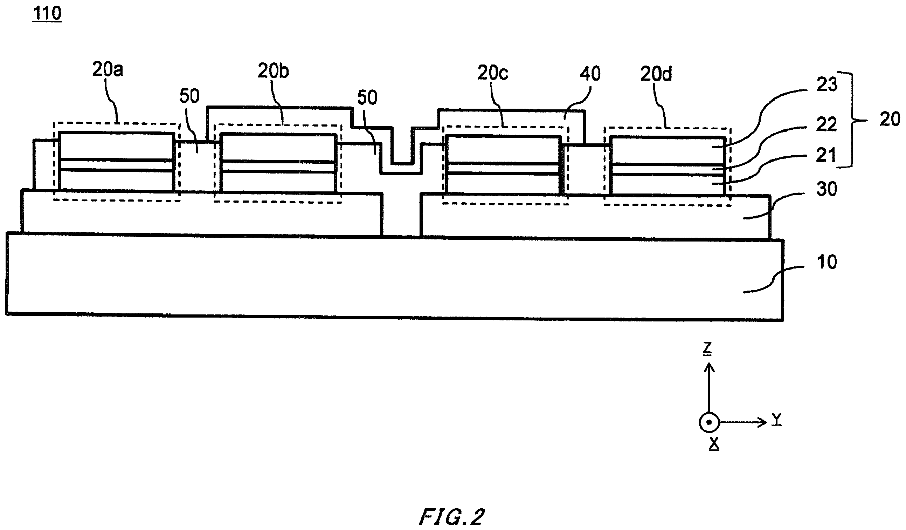

Fig. 1 shows an exemplary plan view of a magnetic detecting part 110. A plan view refers to a figure as seen from the positive-side of the Z-axis direction. Fig. 2 to Fig. 4 each show an exemplary cross-sectional view of the magnetic detecting part 110 in Fig. 1 taken along the line A-A'. The magnetic detecting part 110 includes a substrate 10, magneto-resistance elements 20, lower electrodes 30, an upper electrode 40 and element-separating insulating films 50. In Fig. 1, the substrate 10 and the element-separating insulating films 50 are omitted. The magnetic detecting part 110 detects an external magnetic field.

The substrate 10 may be any of a silicon substrate, a compound semiconductor substrate and a ceramic substrate. Also, the substrate 10 may be a silicon substrate on which an IC is mounted.

The magneto-resistance elements 20 are formed above the substrate 10. The magnetic detecting part 110 in the present example has a plurality of magneto-resistance elements 20a to 20d, which are arrayed in a direction parallel with the plane of the substrate 10. Each magneto-resistance element 20 includes a pinned layer 21, a spacer layer 22 and a free layer 23. The magneto-resistance elements 20 are TMR elements. TMR elements refer to elements in which very thin insulating films are sandwiched between magnetic thin films. The resistance of a TMR element changes depending on the orientation of magnetization of magnetic thin films sandwiching an insulating film. The free layers of the magneto-resistance elements 20 in the present example have rectangular cross-sections with a length L and a width W as seen in a planar view. The planar view refers to a view as seen from the positive-side direction of the Z-axis. The plurality of magneto-resistance elements 20 are arrayed in the longitudinal direction (Y-axis direction) of the magneto-resistance elements 20. The magneto-resistance elements 20 may be connected with each other electrically. In the magneto-resistance elements 20, at least the free layers 23 have to have cross-sections are rectangular in a planar view. In the present example, the longitudinal direction of the magneto-resistance elements 20 coincides with the longitudinal direction of the free layers 23.

The pinned layers 21 are made of a magnetic material whose magnetization is fixed in a predetermined direction. The pinned layers 21 are formed of a combination of materials such as Co, Fe or Ni. In the present specification, the axis of the direction in which magnetization of the pinned layers 21 is fixed is called a magnetically sensitive axis.

The spacer layers 22 are thin-film insulators formed on the pinned layers 21. For example, the spacer layers 22 are formed of an insulating material such as $Al_2O_3$ or MgO.

The free layers 23 are magnetic bodies whose orientation of magnetization changes depending on an external magnetic field. For example, the free layers 23 are soft magnetic materials formed of a combination of materials such as Co, Fe or Ni. The free layers 23 are formed on the spacer layers 22. For example, the magnetization direction of the free layers 23 is generated due to shape anisotropy of the free layers 23, and lies in the longitudinal direction (Y-axis direction) of the magneto-resistance elements 20. The magnetization direction of the free layers 23 in the present example coincides with the array direction of the free layers 23.

The lower electrodes 30 are provided between the substrate 10 and the magneto-resistance elements 20. A lower electrode 30 connects pinned layers 21 of two adjacent magneto-resistance elements 20 with each other. For example, the lower electrodes 30 in the present example connect the magneto-resistance element 20a and the magneto-resistance element 20b, and the magneto-resistance element 20c and the magneto-resistance element 20d, respectively. The lower electrodes 30 are formed of a non-magnetic body, for example.

The upper electrode 40 is provided on the magneto-resistance elements 20. The upper electrode 40 connects free layers 23 provided to two adjacent magneto-resistance elements 20 with each other. For example, the upper electrode 40 in the present example connects the magneto-resistance element 20b and the magneto-resistance element 20c. That is, adjacent magneto-resistance elements 20 are electrically connected either by a lower electrode 30 or by an upper electrode 40. Although the lower electrodes 30 and the upper electrode 40 in the present example have rectangular cross-sections in a planar view, but their shapes are not limited thereto. Also, the lower electrodes 30 and the upper electrode 40 may have equal widths.

The element-separating insulating films 50 electrically separate the free layers of the adjacent magneto-resistance elements 20 from each other. The element-separating insulating films 50 are formed of an insulating material that is used in a general semiconductor manufacturing step. For example, the element-separating insulating films 50 is formed of silicon dioxide $SiO_2$.

As explained above, the magnetic detecting part 110 has the free layers 23 that are magnetized and arrayed in a direction orthogonal to the magnetically sensitive axis. Thereby, the magnetic detecting part 110 can accurately detect a magnetic field oriented in the same direction as the magnetically sensitive axis.

In Fig. 2, side faces of two magneto-resistance elements 20 connected by a lower electrode 30 are completely separated by an element-separating insulating film 50. Being completely separated means that adjacent magneto-resistance elements 20 are physically separated so that they do not contact each other. For example, pinned layers 21, spacer layers 22 and free layers 23 are completely etched between the magneto-resistance element 20a and the magneto-resistance element 20b.

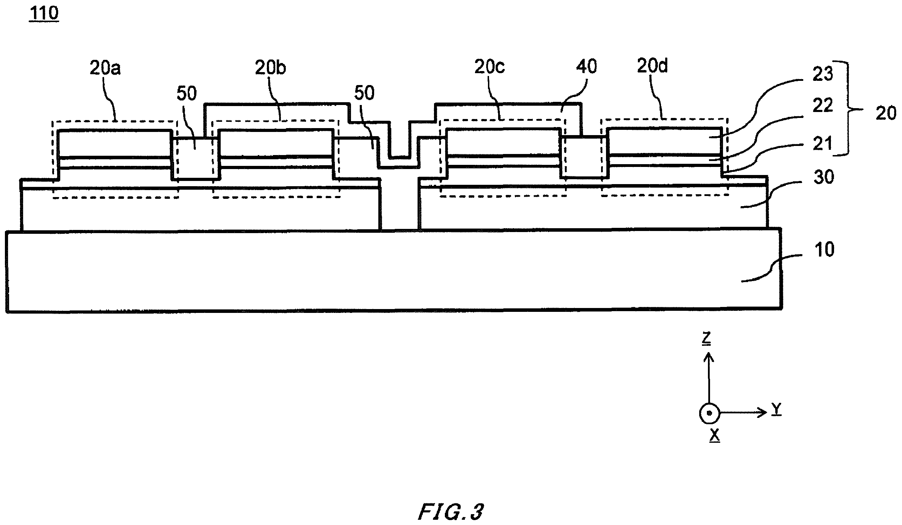

In Fig. 3, two magneto-resistance elements 20 connected by a lower electrode 30 are connected with each other at side faces of their pinned layers 21. For example, spacer layers 22 and free layers 23 are completely etched between the magneto-resistance element 20a and the magneto-resistance element 20b. On the other hand, the pinned layers 21 may not be completely etched but may partially remain between the magneto-resistance element 20a and the magneto-resistance element 20b. Also, the lower electrodes 30 may not be provided, and the pinned layers 21 may be used as pinned layers which also serve as lower electrodes.

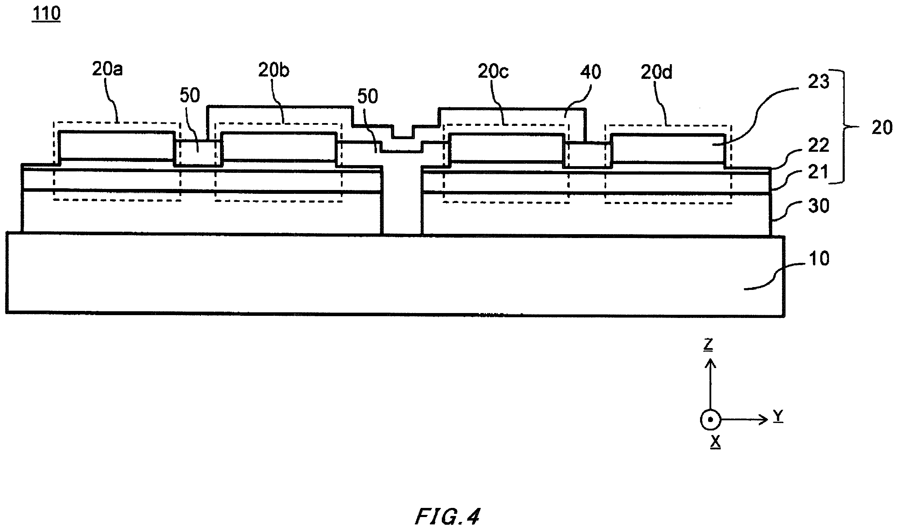

In Fig. 4, two magneto-resistance elements 20 connected by a lower electrode 30 is connected with each other at side faces of their pinned layers 21 and spacer layer 22. For example, free layers 23 are completely etched, but the spacer layers 22 are not completely etched, but partially remain between the magneto-resistance element 20a and the magneto-resistance element 20b. The lower electrodes 30 may not be provided, and the pinned layers 21 may be used as pinned layers which also serve as lower electrodes.

That is, as long as at least free layers 23 of adjacent magneto-resistance elements 20 are completely separated by an element-separating insulating film 50, their pinned layers 21 or spacer layers 22 may contact each other. Also, pinned layers 21 and spacer layers 22 may have any shape among quadrangle, square, parallelogram, trapezoidal, triangle, polygonal, circular and oval in a planar view.

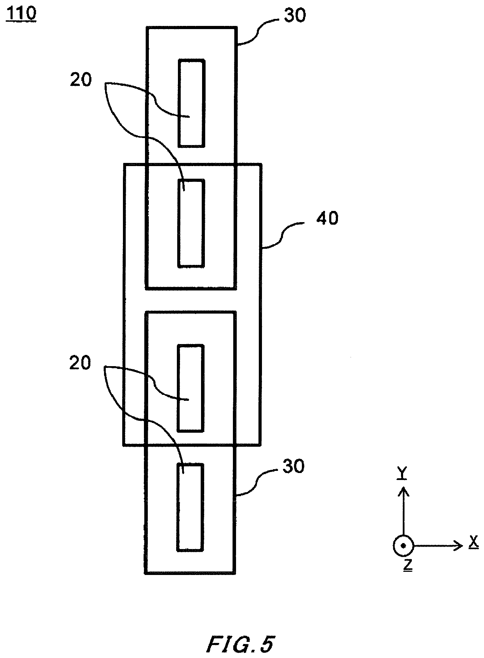

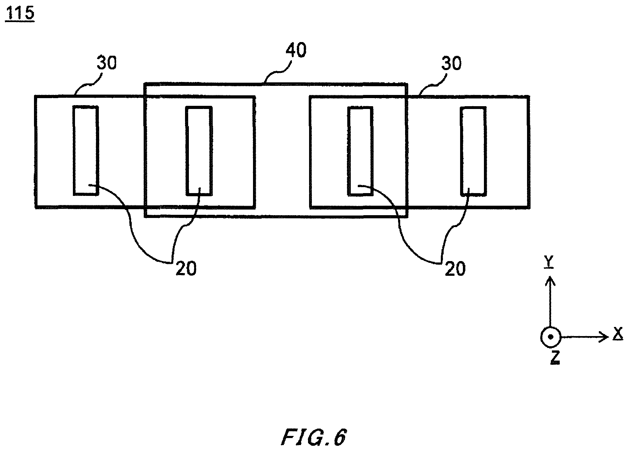

Fig. 5 shows one example of the magnetic detecting part 110. Fig. 6 shows one example of a magnetic detecting part 115. The magnetic detecting part 110 in the present example has a structure basically identical with that of the magnetic detecting part 110 shown in Fig. 1.

The pinned layers 21 of both the magnetic detecting part 110 and the magnetic detecting part 115 have their magnetically sensitive axes in the X-axis direction. Also, the free layers 23 of both the magnetic detecting part 110 and the magnetic detecting part 115 have their longitudinal directions in the Y-axis direction, and their magnetization directions in the Y-axis direction. Therefore, in both the magnetic detecting part 110 and the magnetic detecting part 115, the magnetization direction of the pinned layers 21 and the magnetization direction of the free layer 23 are orthogonal to each other. Also, adjacent magneto-resistance elements 20 are electrically connected either by a lower electrode 30 or by an upper electrode 40. The width of the upper electrode 40 in the present example is large than the width of the lower electrodes 30. The width of the upper electrode 40 may be the same with the width of the lower electrodes 30, or may be smaller than the width of the lower electrodes 30.

However, the array directions of the magneto-resistance elements 20 are different between the magnetic detecting part 110 and the magnetic detecting part 115. In the magnetic detecting part 110, the free layers 23 are arrayed in the Y-axis direction. That is, the longitudinal direction (Y-axis) of a free layer 23 of one magneto-resistance element 20 included in a plurality of magneto-resistance elements 20 and the longitudinal direction (Y-axis) of a free layer 23 of at least one magneto-resistance element 20 adjacent to the one magneto-resistance element 20 coincide with each other, and the at least one magneto-resistance element 20 adjacent to the one magneto-resistance element 20 is arrayed in the longitudinal direction (Y-axis) of the free layer 23 of the one magneto-resistance element 20. Also, the free layers 23 are arrayed in the longitudinal direction (Y-axis) of the free layers 23 which is a direction orthogonal to the magnetically sensitive axis (X-axis) of the pinned layers 21. The arraying method of the free layers 23 in the present example is called vertically-serial arraying.

On the other hand, in the magnetic detecting part 115, the free layers 23 are arrayed in the X-axis direction. That is, a magneto-resistance element 20 adjacent to one magneto-resistance element 20 is arrayed in the transverse direction (X-axis) of the free layer 23 of the one magneto-resistance element 20. Also, the free layers 23 are arrayed in the transverse direction (X-axis) of the free layers 23 which is a direction parallel with the magnetically sensitive axis (X-axis) of the pinned layers 21. The arraying method of the free layers 23 in the present example is called transversely-serial arraying.

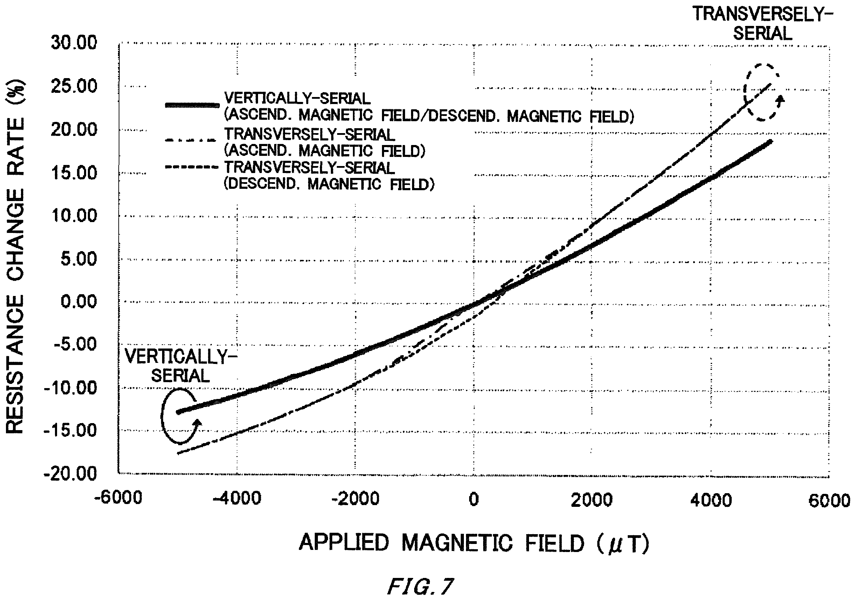

Fig. 7 shows a resistance change rate observed when an external magnetic field is applied to the magnetic detecting part 110 and the magnetic detecting part 115. The horizontal axis indicates an external magnetic field ($\mu$T) applied to a magnetic detecting part, and the vertical axis indicates a resistance change rate (%). The bold line indicates an ascending magnetic field resistance and a descending magnetic field resistance in the case of vertically-serial arraying. The ascending magnetic field resistance change rate refers to a resistance change rate observed when the intensity of an external magnetic field applied to a magnetic detecting part is gradually raised from lower values to higher values. On the other hand, the descending magnetic field resistance change rate refers to a resistance change rate observed when the intensity of an external magnetic field applied to a magnetic detecting part is gradually lowered from higher values to lower values. Also, the alternate long and short dash line indicates the ascending magnetic field resistance change rate in the case of the transversely-serial arraying, and the dotted line indicates the descending magnetic field resistance change rate in the case of the transversely-serial arraying.

The curve indicating the resistance change rate in the case of vertically-serial arraying has an inclination small as compared with the curve indicating the resistance change rate in the case of transversely-serial arraying. That is, in the case of vertically-serial arraying, the change amount of resistance change rate in response to a change in applied magnetic field is small as compared with that in the case of transversely-serial arraying. Here, the resistance change rates of the magnetic detecting part 110 and the magnetic detecting part 115 reach their saturation points after exceeding certain rates. For this reason, when the absolute value of an applied magnetic field becomes a certain value or higher, a change in resistance change rate can no longer be detected. However, because in the case of vertically-serial arraying, the inclination of the resistance change rate is smaller than that in the case of the transversely-serial arraying, the detectable maximum value of an applied magnetic field is larger than that in the case of the transversely-serial arraying. Therefore, in the case of vertically-serial arraying, magnetic field saturation is harder to occur, so the detectable magnetic field range is wider as compared with the case of transversely-serial arraying.

Furthermore, in the case of vertically-serial arraying, the curve indicating the ascending magnetic field resistance change rate and the curve indicating the descending magnetic field resistance change rate overlap. On the other hand, in the case of the transversely-serial arraying, differences are observed between the ascending magnetic field resistance change rate and the descending magnetic field resistance change rate around a portion corresponding to an applied magnetic field of 0. Therefore, as compared with the case of the transversely-serial arraying, in the case of vertically-serial arraying, differences in the ascending magnetic field resistance change rate and the descending magnetic field resistance change rate, that is, the hysteresis, are small. Because the hysteresis is small in the case of vertically-serial arraying, differences in the resistance change rates when an applied magnetic field is an ascending magnetic field and when an applied magnetic field is a descending magnetic field are small, and the detection accuracy is high.

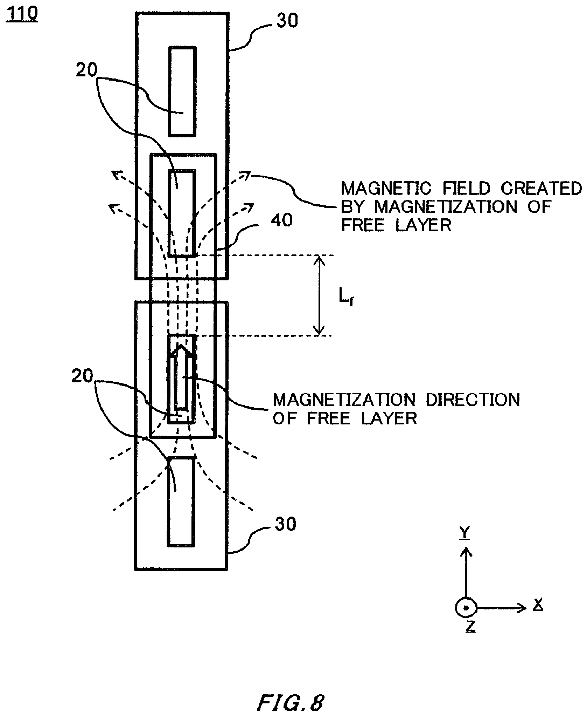

Fig. 8 is a figure for explaining a reason why the detectable magnetic field range becomes wide in the case of vertically-serial arraying as compared with the case of transversely-serial arraying. Because in the case of vertically-serial arraying, the free layers 23 are arrayed in the longitudinal direction (Y-axis direction) of the free layers 23, the magnetic field formed by the free layers 23 of the magneto-resistance elements 20 forms a magnetic field along the magnetization direction (Y-axis direction) of free layers 23 of adjacent magneto-resistance elements 20.

An interval $L_f$ indicates an interval between free layers 23. As the interval $L_f$ decreases, the influence of adjacent free layers 23 increases. The interval $L_f$ may be set to any size depending on a material used or the like. The interval $L_f$ may be 15 $\mu$m or smaller, or may be 5 $\mu$m or 10 $\mu$m. Also, the interval $L_f$ may be any value larger than 0 $\mu$m. When a bias magnetic field is applied in the magnetization direction of the free layers 23, it becomes harder for the magnetization direction of the free layers 23 to rotate. Therefore, in the case of vertically-serial arraying, the resistance change rate in relation to an applied magnetic field becomes small, and the magnetic field range expands as compared with the case of the transversely-serial arraying.

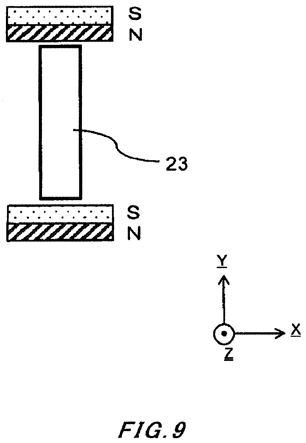

Fig. 9 is a figure for explaining a bias magnetic field applied to a free layer 23. A free layer 23 of each magneto-resistance element 20 functions as a bias magnet relative to an adjacent free layer 23. That is, a bias magnet configured with the north pole and the south pole arrayed in the Y-axis direction is formed spuriously at both ends of each free layer 23. As the interval $L_f$ between free layers 23 decreases, the influence of the magnetic fields from adjacent free layers 23 increases, and the bias effect becomes larger. Such a bias effect occurs in the case of vertically-serial arraying.

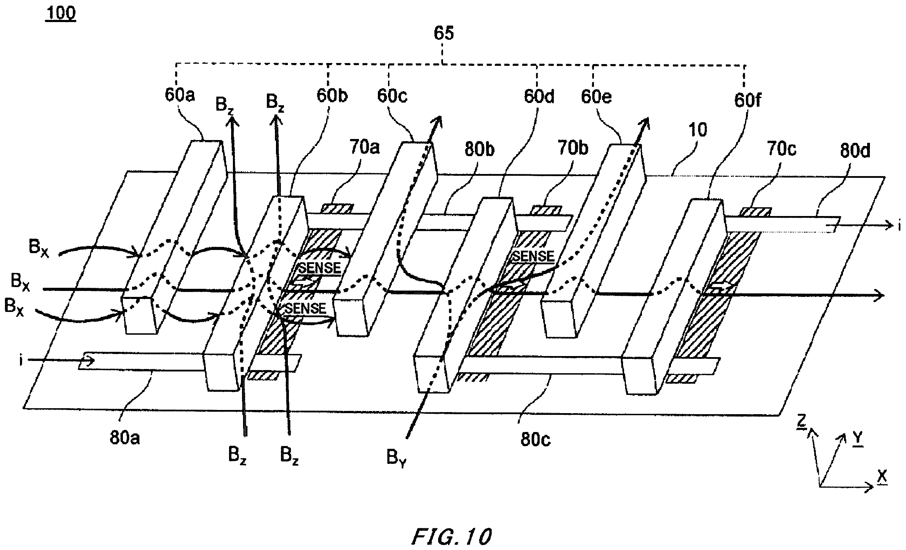

Fig. 10 shows one example of a magnetic sensor 100. The magnetic sensor 100 includes a magnetic converging part 65, magnetic detecting parts 70a to 70c and metallic wires 80a to 80c. The magnetic detecting parts 70 in the present example have TMR elements identical with the magnetic detecting part 110 of a vertically-serial arrangement. The magnetic detecting parts 70 only have to have at least one magnetic detecting part 110 of a vertically-serial arrangement, and not all the magnetic detecting parts 110 need not be of a vertically-serial arrangement. The magnetic sensor 100 detects an input external magnetic field. The external magnetic field can be seen as being made up of external magnetic fields $B_X$, By, $B_Z$ that are uniform in the respective X-axis, Y-axis and Z-axis directions.

The magnetic converging part 65 converges the input external magnetic field to the magnetic detecting parts 70. The magnetic converging part 65 is arranged on the substrate 10 or in the substrate 10. The magnetic converging part 65 has one or more magnetic converging members 60. The magnetic converging part 65 in the present example has magnetic converging members 60a to 60f.

The magnetic converging members 60a to 60f are formed above the magnetic detecting parts 70a to 70c and the metallic wires 80a to 80d. Also, the magnetic converging members 60a to 60f are rectangular parallelepipeds whose thicknesses lie in the Z-axis direction and longitudinal directions lie in the Y-axis direction. Although the corners of the magnetic converging members 60 in the present example are right-angled, at least one of four corners may be rounded or chamfered. Also, the shapes of the magnetic converging members 60a to 60f may be any shape among quadrangle, square, parallelogram, trapezoidal, triangle, polygonal, circular and oval in a planar view. The magnetic converging members 60a to 60f may be formed of a soft magnetic material such as NiFe, NiFeB, NiFeCo or CoFe. The magnetic converging members 60a to 60f are arranged side-by-side in the X-axis direction. The magnetic converging members 60a, 60c and 60e in the present example are arranged shifted in the positive-side of the Y-axis direction relative to the magnetic converging members 60b, 60d and 60f. The magnetic converging members 60a to 60f are substantially parallel with the substrate 10 and substantially parallel with each other.

The magnetic detecting parts 70 are arranged in the proximity of the magnetic converging members 60, and have magnetically sensitive axes oriented parallel with the plane of the substrate 10. The magnetic detecting parts 70 have pinned layers 21 magnetized in the +X-axis direction. The magnetic detecting parts 70a to 70c in the present example are arranged corresponding to the positive-side of the X-axis from the magnetic converging members 60b, 60d and 60f, respectively. The magnetic detecting parts 70 in the present example have rectangular shapes whose longitudinal directions lie in the Y-axis direction in a planar view. Also, the magnetic detecting parts 70 may have any shape among quadrangle, square, parallelogram, trapezoidal, triangle, polygonal, circular and oval in a planar view.

The metallic wires 80 respectively connect the magnetic detecting parts 70. If current i is allowed to flow through the metallic wires 80a to 80d, the current i flows through the magnetic detecting parts 70a to 70c, respectively. Due to the current i flowing through the magnetic detecting parts 70a to 70c, resistance values of the magnetic detecting parts 70a to 70c changed by an external magnetic field can be detected.

A magnetic detecting part 70 responds to a magnetic field applied in the direction of its magnetically sensitive axis. For this reason, although the magnetic detecting part 70 detects a magnetic field applied in the X-axis direction if its magnetically sensitive axis lies in the X-axis direction, it is insensitive to magnetic fields applied in the Y-axis direction and the Z-axis direction. In this case, the magneto-resistance $R_{TMR}$ of the magnetic detecting part 70 is expressed as:

$$R_{TMR} = R_0 + \Delta R_X$$

Here, $R_0$ indicates a resistance value of the magnetic detecting part 70 independent of an external magnetic field. Also, $\Delta R_X$ indicates a resistance change amount of the magnetic detecting part 70 that changes according to the magnitude of an external magnetic field $B_X$.

The external magnetic field $B_X$ is converged by the magnetic converging member 60b, and traverses the magnetic detecting part 70a toward the positive-side of the X-axis direction. Similarly, the external magnetic field $B_X$ traverses the magnetic detecting parts 70b, 70c. That is, the external magnetic field $B_X$ is detected by the magnetic detecting parts 70a to 70c. If the current i is allowed flow through the metallic wires 80a to 80d, the external magnetic field $B_X$ detected by the magnetic detecting parts 70a to 70c can be detected.

The magnetic path of an external magnetic field By is shown by using the three magnetic converging members 60c, 60d and 60e and the magnetic detecting part 70b. If input to the magnetic converging member 60d protruding in the -Y-axis direction, the external magnetic field $B_Y$ branches into and flows through the magnetic converging member 60c and 60e, respectively. When it takes the magnetic path to flow from the magnetic converging member 60d to the magnetic converging member 60c, the external magnetic field By flows toward the negative-side of the X-axis direction.

On the other hand, when it takes the magnetic path to flow from the magnetic converging member 60d to the magnetic converging member 60e, the external magnetic field By flows toward the positive-side of the X-axis direction. That is, the external magnetic field By is converted into a magnetic field oriented in the X-axis direction to traverse the magnetic detecting part 70b. Similarly, the external magnetic field By input to the magnetic converging members 60b and 60f is converted into a magnetic field oriented in the X-axis direction to traverse the magnetic detecting parts 70a, 70c. Thereby, the external magnetic field $B_Y$ is detected by the magnetic detecting parts 70a to 70c. If the current i is allowed to flow through the metallic wires 80a to 80d, the external magnetic field $B_Y$ detected by the magnetic detecting parts 70a to 70c can be detected.

The magnetic path of an external magnetic field $B_Z$ is shown by using the magnetic converging member 60b and the magnetic detecting part 70a. For example, if a magnetic detecting part 70 is formed on the negative-side of the Z-axis relative to a magnetic converging member 60, the external magnetic field $B_Z$ traverses the magnetic detecting part 70a toward the negative-side of the X-axis direction, and a magnetic path converged by the magnetic converging member 60b is formed. That is, the external magnetic field $B_Z$ is converted into a magnetic field oriented in the X-axis direction to traverse the magnetic detecting part 70a. Similarly, the external magnetic field $B_Z$ input to the magnetic converging members 60d and 60f is converted into a magnetic field oriented in the X-axis direction to traverse the magnetic detecting parts 70b, 70c. Thereby, the external magnetic field $B_Z$ is detected by the magnetic detecting parts 70a to 70c. If the current i is allowed flow through the metallic wires 80a to 80d, the external magnetic field $B_Z$ detected by the magnetic detecting parts 70a to 70c can be detected.

As explained above, the magnetic sensor 100 can detect magnetic fields oriented in three axial directions by converting, by means of the magnetic converging members 60a to 60f, the orientation of external magnetic fields into the directions of their magnetically sensitive axes. The magneto-resistances $R_{TMR}$ of the magnetic detecting parts 70a to 70c in the present example are expressed as:

$$R_{TMR} = R_0 \quad + \Delta R_X + \Delta R_Y - \Delta R_Z$$

Here, $\Delta R_Y$ is a resistance change amount that changes according to the magnitude of the external magnetic field By, and $\Delta R_Z$ is a resistance change amount that changes according to the magnitude of the external magnetic field $B_Z$. The reason why only the $\Delta R_Z$ has the different sign is because in the case of the external magnetic field $B_Z$, a magnetic field having been converted into a magnetic field oriented in the X-axis direction traversing the magnetic detecting parts 70a to 70c lies in the negative-side of the X-axis direction.

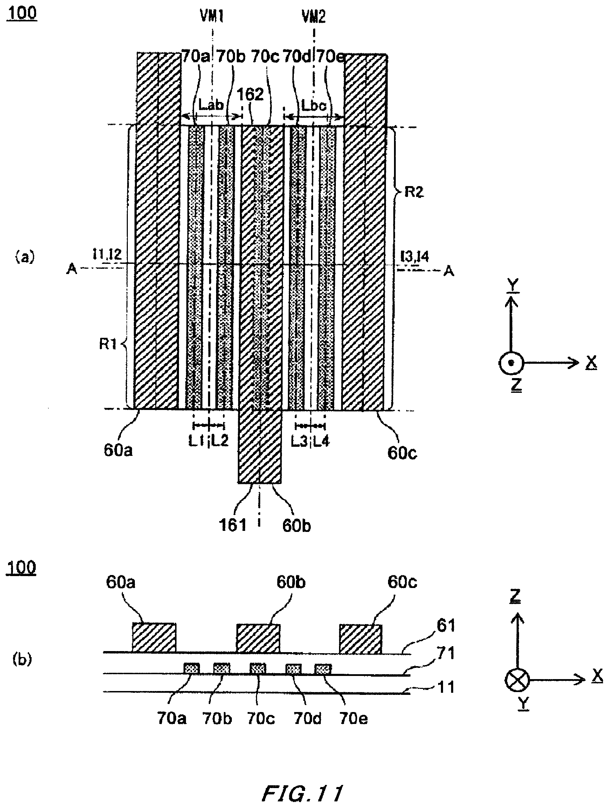

Fig. 11 shows an exemplary configuration of the magnetic sensor 100. (a) of Fig. 11 is a plan view of the magnetic sensor 100, and (b) of Fig. 11 shows a cross-sectional view taken along the line A-A in (a) of Fig. 11.

The magnetic sensor 100 in the present example includes the magnetic converging members 60a to 60c and the magnetic detecting parts 70a to 70e whose magnetically sensitive axes lie in the X-axis direction. The magnetic sensor 100 detects respective magnetic signals of three axes that are orthogonal to each other. The magnetic detecting parts 70a to 70e in the present example respectively have identical structures.

The magnetic converging members 60a to 60c are arranged parallel with each other and side-by-side in the X-axis direction. The magnetic converging member 60a and the magnetic converging member 60c are provided sandwiching the magnetic converging member 60b. Also, the magnetic converging member 60a and the magnetic converging member 60c are arranged shifted in the positive-side of the Y-axis direction relative to the magnetic converging member 60b. More specifically, the plane including one end point 161 and orthogonal to the Y-axis direction (XZ plane) is arranged not to intersect the magnetic converging member 60a and the magnetic converging member 60c, and at the same time, the plane including another end point 162 and orthogonal to the Y-axis direction (XZ plane) is arranged to intersect the magnetic converging member 60a and the magnetic converging member 60c. Thereby, if the external magnetic field By is input to the longitudinal direction of the magnetic converging member 60b, a magnetic flux component that flows from the magnetic converging member 60b to the magnetic converging member 60a and a magnetic flux component that flows from the magnetic converging member 60b to the magnetic converging member 60c are respectively formed. Here, the end point 161 and the end point 162 refer to an end point on the positive-side and an end point, on the negative-side of the Y-axis direction, of the magnetic converging member 60b overlapping a first virtual plane 61.

The first virtual plane 61 indicates any virtual plane substantially parallel with a substrate plane 11. The first virtual plane 61 in the present example corresponds to bottom surfaces of the magnetic converging members 60a to 60c on the negative-side of the Z-axis direction. However, the bottom surfaces of the magnetic converging members 60a to 60c on the negative-side of the Z-axis direction may be planes respectively different from the first virtual plane 61. The shape of a magnetic converging member 60 overlapping the first virtual plane 61 is not limited to a rectangular shape, but it may be any of a quadrangular shape, a parallelogram shape and a trapezoidal shape whose longitudinal direction lies substantially parallel with the Y-axis direction. Thicknesses of the magnetic converging members 60a to 60c in the Z-axis direction may be equal to each other, or may be different from each other.

A first inter-edge distance Lab is the shortest distance between the magnetic converging member 60a and the magnetic converging member 60b overlapping the first virtual plane 61 within a first range R1 and along the X-axis direction. A second inter-edge distance Lbc is the shortest distance between the magnetic converging member 60b and the third magnetic converging member 60c overlapping the first virtual plane 61 within a second range R2 and along the X-axis direction. Here, the first range R1 is a range along the Y-axis direction within which planes orthogonal to the Y-axis direction between the magnetic converging member 60a and the magnetic converging member 60b intersect both the magnetic converging member 60a and the magnetic converging member 60b. Also, the second range R2 is a range along the Y-axis direction within which planes orthogonal to the Y-axis direction between the magnetic converging member 60c and the magnetic converging member 60b intersect both the magnetic converging member 60c and the magnetic converging member 60b.

The first inter-edge distance Lab in the present example is approximately equal to the second inter-edge distance Lbc. For example, one distance of the first inter-edge distance Lab and the second inter-edge distance Lbc may be 0.7 times to 1.3 times larger than the other distance. The first inter-edge distance Lab and the second inter-edge distance Lbc meeting this condition allows the magnetic sensor 100 to have suppressed fluctuation in respective sensitivities to external magnetic fields oriented in three axial directions.

The magnetic detecting parts 70a and 70b are arranged between the magnetic converging member 60a and the magnetic converging member 60b when they are seen in a planar view. The magnetic detecting parts 70a and 70b only have to be at least partially arranged in the first range R1, or may be entirely arranged in the first range R1.

The magnetic detecting parts 70d and 70e are arranged between the magnetic converging member 60b and the magnetic converging member 60c when they are seen in a planar view. Also, the magnetic detecting parts 70d and 70e only have to be partially arranged in the second range R2, or may be entirely arranged in the second range R2.

The magnetic detecting part 70c is arranged to be insensitive to magnetic fields oriented in three axial directions by being covered by the magnetic converging member 60b as seen in a planar view. The magnetic detecting part 70c may be arranged at the center of the magnetic converging member 60b in its transverse direction. Also, the magnetic detecting part 70c only have to be arranged covered by at least one magnetic converging member 60 among the magnetic converging members 60a to 60c. For example, the length of the magnetic converging member 60b in the X-axis direction (width) only have to be within a range that allows it to entirely cover the magnetic detecting part 70c and provides a sufficient magnetic shield effect to the magnetic detecting part 70c. The width of the magnetic converging member 60b only have to be preferably 1.5 times or more, and more preferably three times or more larger than the width of the magnetic detecting part 70c.

The magnetic detecting part 70a is arranged between the magnetic converging member 60a and the magnetic converging member 60b, and is arranged to be proximate to the magnetic converging member 60a. Also, the magnetic detecting part 70b is arranged between the magnetic converging member 60a and the magnetic converging member 60b, and is arranged to be proximate to the magnetic converging member 60b. Being proximate means that a magnetic converging member 60 is arranged so as to change an external magnetic field such that it flows in the direction of the magnetically sensitive axis of a magnetic detecting part 70. For example, assuming that a line in the middle of two proximate sides, one being of the shape of the magnetic converging member 60a overlapping the first virtual plane 61 and another being of the shape of the magnetic converging member 60b overlapping the first virtual plane 61 is a virtual intermediate line VM, the magnetic detecting part 70a overlapping a second virtual plane 71 is arranged to be on the side closer to the magnetic converging member 60a relative to the virtual intermediate line VM.

Also, the magnetic detecting part 70a is arranged such that a distance M11 between two proximate sides, one being of the shape of the magnetic converging member 60a overlapping the first virtual plane 61 and another being of the shape of the magnetic detecting part 70a overlapping the second virtual plane 71, becomes shorter than a distance M12 between two proximate sides, one being of the shape of the magnetic converging member 60b overlapping the first virtual plane 61 and the shape of the magnetic detecting part 70a overlapping the second virtual plane 71. Similarly, the magnetic detecting part 70b is arranged such that the shape of the magnetic detecting part 70b overlapping the second virtual plane 71 is on the side closer to the magnetic converging member 60b relative to the virtual intermediate line VM.

The second virtual plane 71 is any virtual plane substantially parallel with the substrate plane 11. The second virtual plane 71 corresponds to bottom surfaces of the magnetic detecting parts 70a to 70e on the negative-side of the Z-axis direction. Also, although the magnetic detecting parts 70a to 70e are arranged such that their respective bottom surfaces contact the second virtual plane 71, they may be arranged such that the magnetic detecting parts 70a to 70e respectively partially intersect the second virtual plane 71. Also, thicknesses of the magnetic detecting parts 70a to 70e in the Z-axis direction may be equal to each other, or may be different from each other.

In order to define the arrangement of the magnetic detecting parts 70a to 70e, first to fourth inter-intermediate line distances L1 to L4, first and second virtual intermediate lines VM1 and VM2 and first to fourth virtual lines I1 to 14 are used.

The first virtual intermediate line VM1 is a line in the middle of two proximate sides of the magnetic converging member 60a and the magnetic converging member 60b overlapping the first virtual plane 61. The first inter-intermediate line distance L1 is a distance between the first virtual intermediate line VM1 and a line that links middle points of two end sides that form the magnetic detecting part 70a overlapping the second virtual plane 71 and lie vertically across the X-axis direction. Also, the second inter-intermediate line distance L2 is a distance between the first virtual intermediate line VM1 and a line that links middle points of two end sides that form the second magneto-resistance element 70b overlapping the second virtual plane 71 and lie vertically across the X-axis direction.

Similarly, the second virtual intermediate line VM2 is a line in the middle of two proximate sides of the magnetic converging member 60b and the magnetic converging member 60c overlapping the first virtual plane 61. The third inter-intermediate line distance L3 is a distance between the second virtual intermediate line VM2 and a line that links middle points of two end sides that form the magnetic detecting part 70d overlapping the second virtual plane 71 and lie vertically across the X-axis direction. Also, the fourth inter-intermediate line distance L4 is a distance between the second virtual intermediate line VM2 and a line that links middle points of two end sides that form the magnetic detecting part 70e overlapping the second virtual plane 71 and lie vertically across the X-axis direction.

Also, the first virtual line I1 is a straight line parallel with the X-axis direction including a midpoint between end points, in the Y-axis direction, of the magnetic detecting part 70a in the first range R1. The second virtual line I2 is a straight line parallel with the X-axis direction including a midpoint between end points, in the Y-axis direction, of the second magneto-resistance element 70b in the first range R1. Also, the third virtual line I3 is a straight line parallel with the X-axis direction including a midpoint between end points, in the Y-axis direction, of the magnetic detecting part 70d in the second range R2. The fourth virtual line I4 is a straight line parallel with the X-axis direction including a midpoint between end points, in the Y-axis direction, of the magnetic detecting part 70e in the second range R2.

The first inter-intermediate line distance L1 is a length of a line segment linking an intersection of the first virtual line I1 and the first virtual intermediate line VM1 and a midpoint of two end points of the magnetic detecting part 70a at which it crosses the first virtual line I1. Also, the second inter-intermediate line distance L2 is a length of a line segment linking an intersection of the second virtual line I2 and the first virtual intermediate line VM1 and a midpoint of two end points of the second magneto-resistance element 70b at which it crosses the second virtual line I2. Similarly, the third inter-intermediate line distance 3 is a length of a line segment linking an intersection of the third virtual line I3 and the second virtual intermediate line VM2 and a midpoint of two end points of the magnetic detecting part 70c at which it crosses the third virtual line I3. Also, the fourth inter-intermediate line distance L4 is a length of a line segment linking an intersection of the fourth virtual line I4 and the second virtual intermediate line VM2 and a midpoint of two end points of the magnetic detecting part 70d at which it crosses the fourth virtual line I4.

The magnetic detecting parts 70a, 70b, 70d and 70e and the magnetic converging members 60a to 60c are arranged such that the first inter-intermediate line distance L1, the second inter-intermediate line distance L2, the third inter-intermediate line distance 3 and the fourth inter-intermediate line distance L4 become approximately equal to each other. For example, one distance among the first to fourth inter-intermediate line distances L1 to L4 may be 0.7 times to 1.3 times larger than the other distances. The first to fourth inter-intermediate line distances L1 to L4 meeting this condition allows the magnetic sensor 100 to have suppressed fluctuation in respective sensitivities to external magnetic fields oriented in three axial directions.

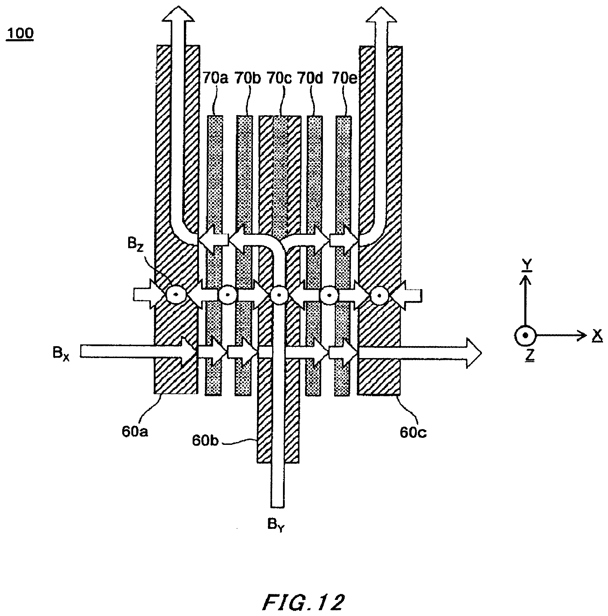

Fig. 12 is a figure for explaining operation of the above-mentioned magnetic sensor 100. The arrows indicate magnetic paths through which external magnetic fields advance.

The external magnetic field $B_X$ is converged by the magnetic converging member 60a to traverse the magnetic detecting part 70a and the magneto-resistance element 70b toward the positive-side of the X-axis direction, is converged by and passes through the magnetic converging member 60b, traverses the magnetic detecting part 70d and the magnetic detecting part 70e toward the positive-side of the X-axis direction, and is converged by the magnetic converging member 60c. At this time, the magnetic detecting parts 70a, 70b, 70d and 70e detect the external magnetic field $B_X$.

The external magnetic field $B_Y$ passes through the magnetic converging member 60b protruding toward the negative-side of the Y-axis, and branches into the magnetic converging members 60a and 60c. When it takes the magnetic path to flow from the magnetic converging member 60b to the magnetic converging member 60a, the external magnetic field $B_Y$ traverses the magneto-resistance elements 70b and 70a toward the negative-side of the X-axis direction. On the other hand, when it takes the magnetic path to flow from the magnetic converging member 60b to the magnetic converging member 60c, the external magnetic field $B_Y$ traverses the magneto-resistance elements 70d and 70e toward the positive-side of the X-axis direction. At this time, the magnetic detecting parts 70a, 70b, 70d and 70d detect magnetic fields oriented in the X-axis direction after being converted direction-wise in proportion to the magnitude of the external magnetic field By.

From the external magnetic field $B_Z$, a magnetic path that traverses the magnetic detecting part 70a toward the negative-side of the X-axis and is converged by the magnetic converging member 60a, and a magnetic path that traverses the magneto-resistance element 70b toward the positive-side of the X-axis direction and is converged by the magnetic converging member 60b are formed. Also, from the external magnetic field $B_Z$, a magnetic path that traverses the magnetic detecting part 70d toward the negative-side of the X-axis direction and is converged by the magnetic converging member 60b, and a magnetic path that traverses the magnetic detecting part 70e toward the positive-side of the X-axis direction and is converged by the magnetic converging member 60c are formed. At this time, the magnetic detecting parts 70a, 70b, 70d and 70e detect magnetic fields oriented in the X-axis direction after being converted direction-wise in proportion to the magnitude of a magnetic field input from the Z-axis direction.

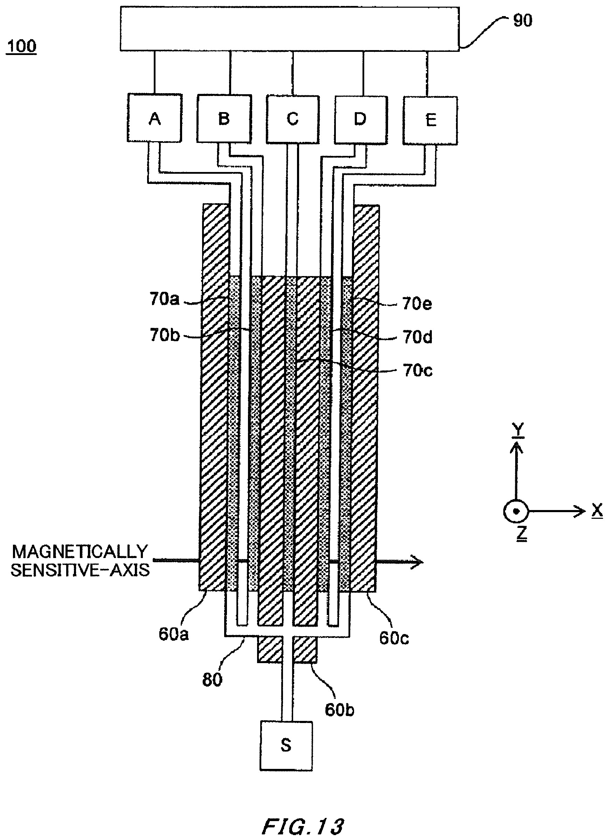

Fig. 13 shows an exemplary configuration of the above-mentioned magnetic sensor 100. The magnetic sensor 100 in the present example includes output terminals A to E and S, and a calculating part 90.

The output terminal S is a terminal at which one of the two terminals of each of the magnetic detecting parts 70a to 70e is electrically coupled at one point. By coupling the terminals at one point, the number of output terminals can be reduced. The output terminals A to E represent output terminals at which the other of the two terminals of each of the magnetic detecting parts 70a to 70e is respectively connected. Assuming that the magneto-resistances between the output terminals A-S, B-S, C-S, D-S and E-S are $R_A$, $R_B$, $R_C$, $R_D$ and $R_E$, the respective magneto-resistances are:

$$R_A = R_0 + \Delta R_X - \Delta R_Y - \Delta R_Z \text{ (Expression 1)}$$

$$R_B = R_0 + \Delta R_X - \Delta R_Y + \Delta R_Z \text{ (Expression 2)}$$

$$R_C = R_0 + \Delta R_X + \Delta R_Y - \Delta R_Z \text{ (Expression 3)}$$

$$R_D = R_0 + \Delta R_X + \Delta R_Y + \Delta R_Z \text{ (Expression 4)}$$

$$R_E = R_0 \text{ (Expression 5)}$$

All of the magneto-resistances of (Expression 1) to (Expression 4) include the resistance change amounts $\Delta R_X$, $\Delta R_Y$ and $\Delta R_Z$ that change according to the magnitudes of external magnetic fields oriented in three axial directions. The signs of $\Delta R_X$, $\Delta R_Y$ and $\Delta R_Z$ correspond to the orientation of magnetic fields oriented in the X-axis direction that traverse the magnetic detecting parts 70a, 70b, 70d and 70e. Because the magneto-resistance of (Expression 5) is insensitive to external magnetic fields oriented in three axial directions, it does not include any of resistance change amounts of three-axis components.

The calculating part 90 is connected to each of the terminals A, B, C. The calculating part 90 performs calculation based on each output from the magnetic detecting parts 70a to 70e. For example, if output signals S corresponding to resistance change amounts that change according to the magnitudes of magnetic fields oriented in respective axes are derived from the magneto-resistances of (Expression 1) to (Expression 5):

From (Expression 1) - (Expression 5),

$$S_A = R_A - R_E = \Delta R_X - \Delta R_Y - \Delta R_Z \text{ (Expression 6)}$$

From (Expression 2) - (Expression 5),

$$S_B = R_B - R_E = \Delta R_X - \Delta R_Y + \Delta R_Z \text{ (Expression 7)}$$

From (Expression 3) - (Expression 5),

$$S_C = R_C - R_E = \Delta R_X + \Delta R_Y - \Delta R_Z \text{ (Expression 8)}$$

From (Expression 4) - (Expression 5),

$$S_D = R_D - R_E = \Delta R_X + \Delta R_Y + \Delta R_Z \text{ (Expression 9)}$$

Furthermore, from (Expression 6) + (Expression 7) + (Expression 8) + (Expression 9),

$$4\Delta R_X = S_A + S_B + S_C + S_D$$

From - (Expression 6) - (Expression 7) + (Expression 8) + (Expression 9),

$$4\Delta R_Y = - S_A - S_B + S_C + S_D$$

From - (Expression 6) + (Expression 7) - (Expression 8) + (Expression 9),

$$4\Delta R_Z = - S_A + S_B - S_C + S_D$$

As explained above, the calculating part 90 in the present example can derive the resistance change amounts $\Delta R_X$, $\Delta R_Y$ $\Delta R_Z$ that change according to the magnitudes of external magnetic fields oriented in three axial directions based on respective outputs from the magnetic detecting parts 70a to 70e. That is, by solving a simultaneous equation about respective resistance values of the magnetic detecting parts 70a to 70e, external magnetic fields oriented in three axial directions can be obtained. In this manner, the magnetic sensor 100 according to the present embodiment can detect external magnetic fields oriented in three axial directions with a simple configuration, so it can realize further size reduction and space-saving of equipment.

Although in the present specification, the magnetic detecting parts 70 employ TMR elements having the spacer layers 22 which are insulation layers, they may employ giant magnet resistance (GMR) elements in which the spacer layers 22 are formed of conductive layers. If GMR elements are employed as the magnetic detecting parts 70, the method of detecting an external magnetic field is similar to that in a case where TMR elements are employed as the magnetic detecting parts 70. Even if GMR elements are employed as the magnetic detecting parts 70, the magnetic sensor 100 can achieve a large magnetic field range and a small hysteresis. Also, the magnetic sensor 100 can detect external magnetic fields oriented in three axial directions with a simple configuration.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

[Explanation of Reference Symbols]

10: substrate; 11: substrate plane; 20: magneto-resistance element; 21: pinned layer; 22: spacer layer; 23: free layer; 30: lower electrode; 40: upper electrode; 50: element-separating insulating film; 60: magnetic converging member; 61: first virtual plane; 65: magnetic converging part; 70: magnetic detecting part; 71: second virtual plane; 80: metallic wire; 90: calculating part; 100: magnetic sensor; 110: magnetic detecting part; 115: magnetic detecting part; 161: end point; 162: end point

**Claims**

1. A magnetic sensor comprising:

    a substrate (10);
    a magnetic converging part (65) that is arranged on the substrate (10) or in the substrate (10) and has one or more magnetic converging members (60);
    a plurality of magnetic detecting parts (70) that are arranged in proximity of the magnetic converging members (60) and have magnetically sensitive axes oriented parallel with a plane of the substrate (10); and

a calculating part (90) that calculates, from an output of the plurality of magnetic detecting parts (70), external magnetic fields oriented in at least two directions among: an external magnetic field oriented in a first-axis direction parallel with the plane of the substrate (10); an external magnetic field oriented in a second-axis direction parallel with the plane of the substrate (10) and vertical to the first-axis direction; and an external magnetic field oriented in a third-axis direction vertical to the plane of the substrate (10), wherein

the magnetic converging part (65) converts, at each magnetic detecting part (70) among the plurality of magnetic detecting parts (70), an external magnetic field oriented in a direction different from the magnetically sensitive-axis direction to a magnetic field oriented in the magnetically sensitive-axis direction,

the each magnetic detecting part (70) includes a plurality of magneto-resistance elements (20) arrayed parallel with the plane of the substrate (10),

each magneto-resistance element (20) among the plurality of magneto-resistance elements (20) includes a laminated-layer structure formed of: a free layer (23) in which a magnetization direction is changed by the external magnetic field; a pinned layer (21) with fixed magnetization; and a spacer layer (22) provided between the free layer (23) and the pinned layer (21), **characterized in that**

a longitudinal direction of the free layer (23) of one magneto-resistance element (20) included in the plurality of magneto-resistance elements (20) coincides with a longitudinal direction of the free layer (23) of at least one magneto-resistance element (20) adjacent to the one magneto-resistance element (20), and

the at least one magneto-resistance element (20) is arrayed in the longitudinal direction of the free layer (23) of the one magneto-resistance element (20); wherein the magnetically sensitive-axis direction coincides with a magnetization direction of the pinned layer (21); wherein the free layer (23) of the one magneto-resistance element (20) and the free layer (23) of the at least one magneto-resistance element (20) are arrayed in a direction orthogonal to the magnetically sensitive axis, and have longitudinal directions in a direction orthogonal to the magnetically sensitive axis.

2. The magnetic sensor according to claim 1, wherein the plurality of magneto-resistance elements (20) are electrically connected with each other.

3. The magnetic sensor according to claim 1 or 2, wherein when an external magnetic field is not applied, the magnetization direction of the free layer (23) of the one magneto-resistance element (20) coincides with the magnetization direction of the free layer (23) of the magneto-resistance element (20) adjacent to the one magneto-resistance element (20).

4. The magnetic sensor according to any one of Claims 1 to 3, wherein an interval between the free layer (23) of the magneto-resistance element (20) and the free layer (23) of the magneto-resistance element (20) adjacent thereto is 15 $\mu$m or smaller.

5. The magnetic sensor according to any one of Claims 1 to 4, wherein the calculating part (90) calculates, from an output of the plurality of magnetic detecting parts (70), external magnetic fields oriented in the first to third-axis directions.

6. The magnetic sensor according to any one of Claims 1 to 5, wherein the spacer layer (22) is an insulation layer.

7. The magnetic sensor according to any one of Claims 1 to 5, wherein the spacer layer (22) is a conductive layer.

**Patentansprüche**

1. Magnetischer Sensor, umfassend:

ein Substrat (10);
einen magnetischen konvergierenden Teil (65), welcher auf dem Substrat (10) oder in dem Substrat (10) angeordnet ist und ein oder mehrere magnetische konvergierende Elemente (60) aufweist;
eine Vielzahl von magnetischen Erfassungsteilen (70), welche in der Nähe der magnetischen konvergierenden Elemente (60) angeordnet sind und magnetisch sensitive Achsen aufweisen, welche parallel zu einer Ebene des Substrats (10) ausgerichtet sind; und
einen Berechnungsteil (90), welcher von einer Ausgabe von der Vielzahl von magnetischen Erfassungsteilen (70) externe magnetische Felder berechnet, welche in zumindest zwei Richtungen ausgerichtet sind, darunter:
ein externes magnetisches Feld, welches in einer ersten Achsenrichtung parallel zu der Ebene des Substrats (10) ausgerichtet ist; ein externes magnetisches Feld, welches in einer zweiten Achsenrichtung parallel zu der Ebene des Substrats (10) und vertikal zu der ersten Achsenrichtung ausgerichtet ist; und ein externes magnetisches Feld, welches in einer dritten Achsenrichtung vertikal zu der Ebene des Substrats (10) ausgerichtet ist, wobei

der magnetisch konvergierende Teil (65) an jedem magnetischen Erfassungsteil (70) aus der Vielzahl von magnetischen Erfassungsteilen (70) ein externes magnetisches Feld, welches in einer Richtung ausgerichtet ist, welche sich von der magnetisch sensitiven Achsenrichtung unterscheidet, in ein magnetisches Feld, welches in der magnetisch sensitiven Achsenrichtung ausgerichtet ist, umwandelt,

der jede magnetische Erfassungsteil (70) eine Vielzahl von magnetoresistiven Elementen (20) beinhaltet, welche parallel zu der Ebene des Substrats (10) angeordnet sind,

jedes magnetoresistive Element (20) aus der Vielzahl von magnetoresistiven Elementen (20) eine Laminatschichtstruktur beinhaltet, welche gebildet ist aus: einer freien Schicht (23), in welcher eine Magnetisierungsrichtung durch das externe magnetische Feld geändert wird; eine fixierte Schicht (21) mit fixer Magnetisierung; und eine Abstandsschicht (22), welche zwischen der freien Schicht (23) und der fixierten Schicht (21) angeordnet ist, **dadurch gekennzeichnet, dass**

eine Längsrichtung der freien Schicht (23) von einem magnetoresistiven Element (20), welches in der Vielzahl von magnetoresistiven Elementen (20) beinhaltet ist, mit einer Längsrichtung der freien Schicht (23) von zumindest einem magnetoresistiven Element (20), welches zu dem einen magnetoresistiven Element (20) benachbart ist, zusammenfällt, und

das zumindest eine magnetoresistive Element (20) in der Längsrichtung der freien Schicht (23) des einen magnetoresistiven Elements (20) angeordnet ist; wobei die magnetisch sensitive Achsenrichtung mit einer Magnetisierungsrichtung der fixierten Schicht (21) zusammenfällt; wobei die freie Schicht (23) des einen magnetoresistiven Elements (20) und die freie Schicht (23) des zumindest einen magnetoresistiven Elements (20) in einer Richtung senkrecht zu der magnetisch sensitiven Achse angeordnet sind und Längsrichtungen in einer Richtung senkrecht zu der magnetisch sensitiven Achse aufweisen.

2. Magnetischer Sensor nach Anspruch 1, wobei die Vielzahl von magnetoresistiven Elementen (20) miteinander elektrisch verbunden sind.

3. Magnetischer Sensor nach Anspruch 1 oder 2, wobei ein externes magnetisches Feld nicht angewendet wird, die Magnetisierungsrichtung der freien Schicht (23) des einen magnetoresistiven Elements (20) mit der freien Schicht (23) des magnetoresistiven Elements (20) zusammenfällt, welches zu dem einen magnetoresistiven Element (20) benachbart ist.

4. Magnetischer Sensor nach einem der Ansprüche 1 bis 3, wobei ein Intervall zwischen der freien Schicht (23) des magnetoresistiven Elements (20) und der freien Schicht (23) des magnetoresistiven Elements (20), welches dazu benachbart ist, 15 $\mu$m oder weniger ist.

5. Magnetischer Sensor nach einem der Ansprüche 1 bis 4, wobei der Berechnungsteil (90) von einer Ausgabe von der Vielzahl von magnetischen Erfassungsteilen (70) externe magnetische Felder berechnet, welche in der ersten bis dritten Achsenrichtung ausgerichtet sind.

6. Magnetischer Sensor nach einem der Ansprüche 1 bis 5, wobei die Abstandsschicht (22) eine Isolationsschicht ist.

7. Magnetischer Sensor nach einem der Ansprüche 1 bis 5, wobei die Abstandsschicht (22) eine leitende Schicht ist.


**Revendications**

1. Capteur magnétique comprenant :

un substrat (10) ;
une partie magnétique convergente (65) qui est agencée sur le substrat (10) ou dans le substrat (10) et possède un ou plusieurs éléments magnétiques convergents (60) ;
une pluralité de parties magnétiques de détection (70) qui sont agencées à proximité des éléments magnétiques convergents (60) et possèdent des axes à sensibilité magnétique orientés parallèlement à un plan du substrat (10) ; et
une partie de calcul (90) qui calcule, à partir d'une sortie de la pluralité de parties magnétiques de détection (70), des champs magnétiques externes orientés dans au moins deux directions parmi : un champ magnétique externe orienté en direction d'un premier axe parallèle au plan du substrat (10) ; un champ magnétique externe orienté en direction d'un deuxième axe parallèle au plan du substrat (10) et perpendiculaire à la direction du premier axe ; et un champ magnétique externe orienté en direction d'un troisième axe perpendiculaire au plan du substrat (10), dans lequel

la partie magnétique convergente (65) transforme, au niveau de chaque partie magnétique de détection (70) parmi la pluralité de parties magnétiques de détection (70), un champ magnétique externe orienté dans une direction différente de la direction de l'axe à sensibilité magnétique en un champ magnétique orienté dans la direction de l'axe à sensibilité magnétique,

chaque partie magnétique de détection (70) comporte une pluralité d'éléments de magnétorésistance (20) disposés parallèlement au plan du substrat (10),

chaque élément de magnétorésistance (20) parmi la pluralité d'éléments de magnétorésistance (20) comporte une structure de couches stratifiées formée de la façon suivante : une couche libre (23) dans laquelle une direction de magnétisation est modifiée par le champ magnétique externe ; une couche bloquée (21) à magnétisation fixe; et une couche d'espacement (22) prévue entre la couche libre (23) et la couche bloquée (21), **caractérisé en ce que**

une direction longitudinale de la couche libre (23) d'un élément de magnétorésistance (20) inclus dans la pluralité d'éléments de magnétorésistance (20) coïncide avec une direction longitudinale de la couche libre (23) d'au moins un élément de magnétorésistance (20) adjacent à l'élément de magnétorésistance (20), et

l'au moins un élément de magnétorésistance (20) est disposé dans la direction longitudinale de la couche libre (23) de l'élément de magnétorésistance (20); dans lequel la direction de l'axe à sensibilité magnétique coïncide avec une direction de magnétisation de la couche bloquée (21); dans lequel la couche libre (23) de l'élément de magnétorésistance (20) et la couche libre (23) de l'au moins un élément de magnétorésistance (20) sont disposées dans une direction perpendiculaire à l'axe à sensibilité magnétique, et ont des directions longitudinales dans une direction perpendiculaire à l'axe à sensibilité magnétique.

2. Capteur magnétique selon la revendication 1, dans lequel la pluralité d'éléments de magnétorésistance (20) sont reliés électriquement les uns aux autres.

3. Capteur magnétique selon les revendications 1 ou 2, dans lequel lorsqu'aucun champ magnétique externe n'est appliqué, la direction de magnétisation de la couche libre (23) de l'élément de magnétorésistance (20) coïncide avec la direction de magnétisation de la couche libre (23) de l'élément de magnétorésistance (20) adjacent à l'élément de magnétorésistance (20).

4. Capteur magnétique selon l'une quelconque des revendications 1 à 3, dans lequel un intervalle entre la couche libre (23) de l'élément de magnétorésistance (20) et la couche libre (23) de l'élément de magnétorésistance (20) adjacent à celui-ci est inférieur ou égal à 15 μm.

5. Capteur magnétique selon l'une quelconque des revendications 1 à 4, dans lequel la partie de calcul (90) calcule, à partir d'une sortie de la pluralité de parties magnétiques de détection (70), des champs magnétiques externes orientés dans les directions du premier au troisième axe.

6. Capteur magnétique selon l'une quelconque des revendications 1 à 5, dans lequel la couche d'espacement (22) est une couche d'isolation.

7. Capteur magnétique selon l'une quelconque des revendications 1 à 5, dans lequel la couche d'espacement (22) est une couche conductrice.

<u>110</u>

*FIG.1*

110

EP 3 199 965 B1

*FIG.2*

*FIG.3*

110

20a          20b          20c    40   20d
                                            23  ⎫
    50              50                          ⎬ 20
                                            22  ⎪
                                            21  ⎭
                                            30

                                            10

Z

X → Y

*FIG.4*

EP 3 199 965 B1

110

30

20

40

20

30

Y

Z

X

*FIG.5*

*FIG.6*

FIG.7

EP 3 199 965 B1

110

30

20

MAGNETIC FIELD CREATED
BY MAGNETIZATION OF
FREE LAYER

40

$L_f$

20

MAGNETIZATION DIRECTION
OF FREE LAYER

30

Y

X

Z

*FIG.8*

S
N

23

S
N

Y

X

Z

FIG.9

*FIG.10*

EP 3 199 965 B1

FIG.11

FIG.12

FIG.13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006003116 A
- JP 2006010461 A
- JP H7169026 B
- JP 2002071381 A
- JP 2004006752 A
- JP 2003282996 A

- WO 2011068146 A
- US 2013299930 A1
- US 2014159717 A1
- JP 2014153054 A
- WO 2014101622 A1
- US 2013221949 A1